# EUROPÄISCHE PATENTANMELDUNG

(11) **EP 1 802 192 A1**
(43) Veröffentlichungstag der Anmeldung: **27.06.2007**
(21) Anmeldenummer: 06126315.8
(22) Anmeldetag: 18.12.2006
(51) Int. Cl.: H05K 13/08, H05K 13/04

(54) **Verfahren für die Montage eines Flipchips auf einem Substrat**

(30) Priorität: 22.12.2005 EP 05112853
(71) Anmelder: Unaxis International Trading Ltd, 6330 Cham (CH)
(72) Erfinder: Grueter, Ruedi, 6018, Buttisholz (CH); Blessing, Patrick, 8800, Thalwil (CH); Werne, Dominik, 6315, Oberaegeri (CH)
(74) Vertreter: Falk, Urs

(57) **Zusammenfassung**

Die Erfindung betrifft ein Verfahren für die Montage eines auf einer Oberfläche mit Bumps (1) versehenen Halbleiterchips (2) auf einem Substratplatz (3) eines Substrats (4), wobei die Bumps (1) in Kontakt mit entsprechenden Pads (10) des Substratplatzes (3) gebracht werden. Am Bondkopf (6) sind Referenzmarken (12, 13) angebracht, die die Vermessung der Ist-Lage des Halbleiterchips (2) als auch die Vermessung der Ist-Lage des Substratplatzes (3) bezüglich eines durch die Referenzmarken (12, 13) definierten Koordinatensystems ermöglichen. Durch thermische Einflüsse bedingte Lageveränderungen der einzelnen Komponenten des Montageautomaten können kompensiert werden, ohne dass ständig Kalibrierungsvorgänge durchgeführt werden müssen.

## Beschreibung

Die Erfindung betrifft ein Verfahren für die Montage eines Flipchips auf einem Substrat. Ein Flipchip ist ein Halbleiterchip, der eine Oberfläche mit sogenannten Bumps aufweist, über die die elektrischen Verbindungen mit dem Substrat hergestellt werden.

Bei der Montage der Halbleiterchips auf einem Substrat wird das Substrat in der Regel auf einer horizontal ausgerichteten Auflagefläche bereitgestellt und die Halbleiterchips werden auf einem Wafertisch bereitgestellt, wobei die elektrischen Anschlussflächen des Halbleiterchips nach oben zeigen. Der Halbleiterchip wird von einem Bondkopf eines Montageautomaten, eines sogenannten Die Bonders, vom Wafertisch entnommen und auf dem Substrat platziert. Dieses Montageverfahren ist in der Fachwelt als Epoxy Die Bonding oder Softsolder Die Bonding bekannt, je nachdem ob der Halbleiterchip mit Epoxy auf das Substrat geklebt oder mit Lot auf das Substrat gelötet wird. Von diesem Montageverfahren unterscheidet sich das Flipchip Verfahren, bei dem die elektrische wie auch die mechanische Verbindung zwischen dem Halbleiterchip und dem Substrat über die Bumps hergestellt wird. Damit der Halbleiterchip mit den Bumps montiert werden kann, muss er nach der Entnahme vom Wafertisch um 180° gewendet (geflippt) werden, daher der Name Flipchip.

Beim Flipchip Verfahren müssen die Bumps des Halbleiterchips in Kontakt mit den elektrischen Anschlussflächen des Substrats, den sogenannten Pads, gebracht werden. Die Anforderungen an die Platzierungsgenauigkeit sind beim Flipchip Verfahren deshalb um einiges grösser als beim Epoxy Die Bonding. Um derart präzise Montageautomaten bauen zu können, wird heute sehr viel Aufwand in die Genauigkeit der mechanischen Bewegungsachsen gesteckt. Ein solcher Montageautomat umfasst beispielsweise eine Flipvorrichtung, die den Halbleiterchip vom Wafertisch entnimmt und wendet, eine Pick and Place Einrichtung mit einem Bondkopf, der den geflippten Halbleiterchip von der Flipvorrichtung übernimmt und auf dem Substrat platziert, und drei Kameras, wobei die erste Kamera ein Bild des auf dem Wafertisch präsentierten Halbleiterchips, die zweite Kamera ein Bild des vom Bondkopf aufgenommenen, bereits gewendeten Halbleiterchips und somit Flipchips, d.h. ein Bild der mit den Bumps versehenen Oberfläche des Halbleiterchips, und die dritte Kamera ein Bild des Substrats mit den Pads aufnimmt. Die Bilder der zweiten und dritten Kamera werden ausgewertet, um die Lage des Flipchips und die Lage des Substrats in Bezug auf die Bewegungsachse(n) des Bondkopfs zu bestimmen, damit der Bondkopf den Flipchip lagegenau auf dem Substrat platzieren kann. Temperaturschwankungen verursachen Längenausdehnungen und haben zur Folge, dass sich die Lage der Kameras relativ zueinander und zu den Bewegungsachsen des Bondkopfs ändert. Um den Einfluss von Temperaturschwankungen auf die Platzierungsgenauigkeit zu minimieren, werden die Distanzen zwischen der zweiten und der dritten Kamera und dem mechanischen Transportsystem so klein wie möglich gehalten. So ist beispielsweise ein Montageautomat bekannt, bei dem der Bondkopf mit dem Flipchip in eine Position oberhalb des Substrats gebracht, dann die zweite und dritte Kamera zwischen den Flipchip und das Substrat eingeschwenkt, der Bondkopf aufgrund der von der zweiten und dritten Kamera gelieferten Bilder neu positioniert, die zweite und dritte Kamera wieder ausgeschwenkt und der Bondkopf abgesenkt wird. Bei diesem Montageverfahren geht der Erhalt der Platzierungsgenauigkeit aber auf Kosten des Durchsatzes.

Der Erfindung liegt die Aufgabe zugrunde, ein Verfahren für die Montage eines Flipchips zu entwickeln, das hohe Platzierungsgenauigkeit und grossen Durchsatz ermöglicht.

Die genannte Aufgabe wird erfindungsgemäss gelöst durch die Merkmale des Anspruchs 1.

Die Erfindung betrifft also ein Verfahren für die Montage eines auf einer Oberfläche mit Bumps versehenen Halbleiterchips auf einem Substratplatz eines Substrats, wobei die Bumps in Kontakt mit entsprechenden Pads des Substratplatzes gebracht werden. Die Positionierung des Halbleiterchips über dem Substratplatz erfolgt mittels dreier Bewegungsachsen, die zwei translatorischen und einem rotativen Freiheitsgrad entsprechen. Der Halbleiterchip wird von einem Wafertisch aufgenommen, um eine zur Oberfläche mit den Bumps parallele Achse um 180° gewendet und an einen Bondkopf übergeben. Der Bondkopf enthält einen um eine Achse drehbaren Chipgreifer. Parallel dazu wird der nächste Substratplatz bereitgestellt. Die Erfindung ist gekennzeichnet durch die folgenden Schritte:
A) Aufnehmen eines Bildes des Halbleiterchips mit einer ersten Kamera (die im Fachjargon als Flipvision bezeichnet wird), wobei das Bild sowohl die Bumps des Halbleiterchips als auch am Bondkopf angebrachte Referenzmarken enthält, und wobei sich die drei Bewegungsachsen in ersten Positionen befinden. Bestimmen der Position und Orientierung der Ist-Lage des Halbleiterchips in Bezug auf ein durch die Referenzmarken definiertes Koordinatensystem und Berechnen eines ersten Korrekturvektors v₁, der die Abweichung der Ist-Lage des Halbleiterchips von seiner Soll-Lage beschreibt,
B) Aufnehmen eines ersten Bildes mit einer zweiten Kamera (die im Fachjargon als Bondvision bezeichnet wird), wobei im Bild der Substratplatz sichtbar ist, Bestimmen der Position und Orientierung des Substratplatzes in Bezug auf das durch die Referenzmarken definierte Koordinatensystem, wobei für die Positionen der Referenzmarken fiktive Positionen benützt werden, die sie einnehmen würden, wenn die drei Bewegungsachsen aus den ersten Positionen um einen Vektor v in zweite Positionen bewegt worden wären, und Berechnen eines zweiten Korrekturvektors v₂, der die Abweichung der Ist-Lage des Substratplatzes von seiner Soll-Lage beschreibt,
C) Berechnen der anzufahrenden Positionen der drei Bewegungsachsen unter Berücksichtigung des Vektors v und der beiden Korrekturvektoren v₁ und v₂,
D) Bewegen der drei Bewegungsachsen in diese berechneten Positionen,
E) Aufnehmen eines zweiten Bildes mit der zweiten Kamera, wobei im zweiten Bild die am Bondkopf angebrachten Referenzmarken sichtbar sind, und Bestimmen der Ist-Lage der Referenzmarken,
F) Berechnen eines dritten Korrekturvektors v₃, der die Abweichung der Ist-Lage der Referenzmarken von der bei der Auswertung des ersten von der zweiten Kamera aufgenommenen Bildes angenommenen fiktiven Positionen der Referenzmarken beschreibt,
G) Anpassen des Vektors v zu v = v + v₃,
H) Falls mindestens eine Komponente des dritten Korrekturvektors v₃ grösser als ein vorgegebener Grenzwert ist, Bewegen mindestens der dieser Komponente entsprechenden Bewegungsachse in eine neue, korrigierte Position,
I) Absetzen des Halbleiterchips auf dem Substratplatz.

Die Schritte A, B, C, D und I werden immer durchgeführt. Die Schritte E, F, G und H werden durchgeführt für die Montage des ersten Halbleiterchips, der bei Aufnahme der Produktion oder nach einem Unterbruch der Produktion montiert wird, um sicherzustellen, dass dieser Halbleiterchip am richtigen Ort platziert wird. Der Vektor v beschreibt den Abstand zwischen den optischen Achsen der beiden Kameras und die Drehlage der beiden Kameras zueinander. Der Vektor v wird durch die Schritte E, F, G und H jeweils aktualisiert. Der Vektor v ändert sich aufgrund thermischer Einflüsse relativ langsam. Die Schritte E, F, G und H können zwar bei der Montage jedes Halbleiterchips durchgeführt werden, wodurch eine sehr hohe Platzierungsgenauigkeit erreicht wird. Die Schritte E, F, G und H können aber auch nur sporadisch durchgeführt werden, z. B. bei jedem n-ten Halbleiterchip oder in vorbestimmten Zeitabständen. Falls nötig, können die Schritte E, F, G und H mehrmals nacheinander durchgeführt werden, bis alle Komponenten des dritten Korrekturvektors v₃ kleiner als ein vorgegebener Grenzwert sind.

Die Referenzmarken sind am Bondkopf angebracht. Darunter ist zu verstehen, dass die Referenzmarken entweder am (nicht rotierenden) Gehäuse des Bondkopfs oder an dem um die Achse drehbaren Chipgreifer angebracht sind.

Die Erfindung wird nachfolgend anhand eines Ausführungsbeispiels und anhand der Zeichnung näher erläutert. Die Figuren sind schematisch und nicht massstäblich gezeichnet.

Es zeigen:
- Fig. 1: die für das Verständnis der Erfindung nötigen Komponenten eines Montageautomaten für die Montage eines mit Bumps versehenen Halbleiterchips als Flipchip auf einem Substrat,
- Fig. 2, 3: geometrische Darstellungen eines mathematischen Sachverhalts, und
- Fig. 4, 5: Beispiele für Referenzmarken.

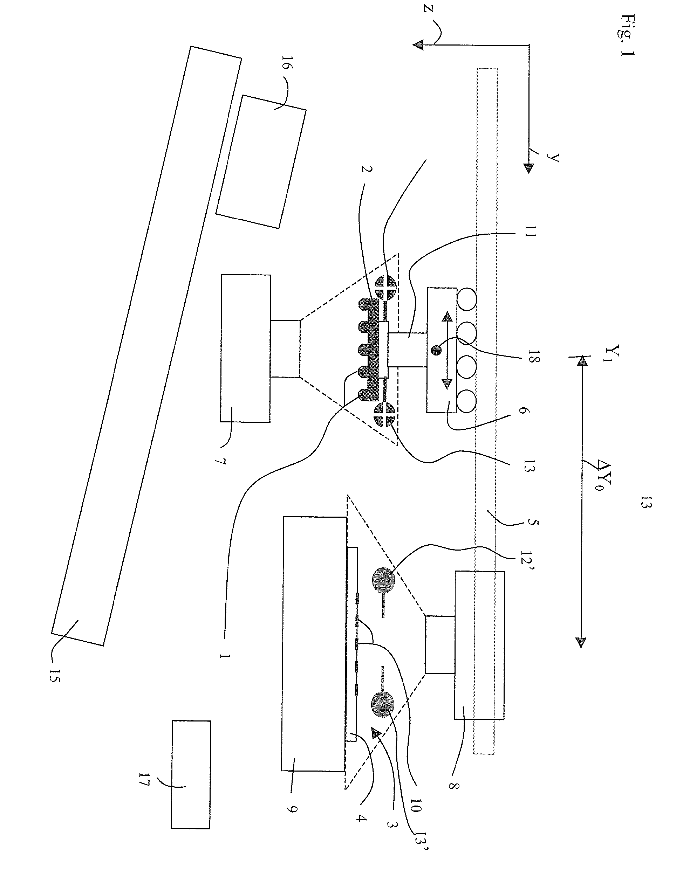

Die Fig. 1 zeigt den Grundgedanken der Erfindung anhand einer schematischen Darstellung der für das Verständnis der Erfindung erforderlichen Komponenten eines Montageautomaten für die Montage eines mit Bumps 1 versehenen Halbleiterchips 2, eines sogenannten Flipchips, auf einem Substratplatz 3 eines Substrats 4. Die Koordinaten eines kartesischen Koordinatensystems sind mit x, y und z bezeichnet, wobei die x-Koordinate senkrecht zur Zeichenebene verläuft. Der Montageautomat umfasst ein sogenanntes Pick and Place System mit einem entlang einer in y-Richtung verlaufenden Achse 5 hin und her bewegbaren Bondkopf 6, und zwei Kameras 7 und 8. Die Position des Bondkopfs 6 auf der Achse 5 wird mittels eines an sich bekannten und hier nicht näher erläuterten Positionsmess- und Regelkreises geregelt. Die Substrate 4 werden von einem Transportsystem in x-Richtung zu einer Bondstation 9 transportiert, wo der Bondkopf 6 jeweils einen Halbleiterchip 2 auf einem Substratplatz 3 absetzt, der den Bumps 1 zugeordnete elektrische Kontaktflächen, sogenannte Pads 10, aufweist. Der Bondkopf 6 enthält einen in z-Richtung auf und ab bewegbaren und um seine Längsachse, d.h. hier um die z-Achse drehbaren Chipgreifer 11. Der Bondkopf 6 ist zudem mit drei im Abstand zueinander angeordneten Referenzmarken 12, 13 und 14 versehen (in der Fig. 1 sind nur die Referenzmarken 12 und 13 sichtbar), deren Aufgabe im folgenden im Detail erläutert wird. Bei dem in der Fig. 1 gezeigten Beispiel sind die Referenzmarken 12, 13 und 14 am Chipgreifer 11 angebracht, der auch ein Teil des Bondkopfs 6 ist. Die Referenzmarken 12, 13 und 14 könnten aber alternativ am Gehäuse des Bondkopfs 6 angebracht sein. Die Halbleiterchips 2 werden auf einem Wafertisch 15 bereitgestellt. Der Montageautomat umfasst weiter eine Flipvorrichtung 16, sowie eine Steuer- und Recheneinheit 17, die den Montageautomaten steuert. Bei der in der Fig. 1 gezeigten Schnittdarstellung sind fünf in einer Reihe nebeneinander liegende Bumps 1 sichtbar, denen auf dem Substratplatz 3 fünf in einer Reihe nebeneinander liegende Pads 10 entsprechen.

Damit die Bumps 1 des Halbleiterchips 2 lagegenau auf den Pads 10 des Substratplatzes 3 platziert werden können, so dass die Bumps 1 und die Pads 10 mit der erforderlichen Genauigkeit aufeinander zu liegen kommen, müssen drei Freiheitsgrade in Übereinstimmung gebracht werden, nämlich die durch zwei Koordinaten charakterisierte translatorische Lage und die durch einen Drehwinkel charakterisierte Orientierung (Drehlage) des Halbleiterchips 2 in Bezug auf die Lage und Orientierung (Drehlage) des Substratplatzes 3. Jedem Freiheitsgrad ist mindestens eine Bewegungsachse zugeordnet. Jeder Bewegungsachse ist ein Antrieb zugeordnet, damit die entsprechende Bewegung durchgeführt werden kann. Die drei Freiheitsgrade könnten also durch die x-Achse des Transportsystems für die Substrate 4, die y-Achse des Bondkopfs 6 und den Drehwinkel θ des Chipgreifers 11 realisiert werden. Allerdings ist es vorteilhaft, den Montageautomaten mit einer weiteren Bewegungsachse 18 auszurüsten, die eine Bewegung des Bondkopfs 6 in x-Richtung ermöglicht, wobei diese Bewegungsachse 18 zwar nur Bewegungen im Submillimeterbereich ausführen kann, dafür aber markant schneller als das Transportsystem für die Substrate 4 ist.

Im Idealfall, d.h. wenn sich der vom Bondkopf 6 aufgenommene Halbleiterchip 2 in seiner Soll-Lage befindet und wenn sich der Substratplatz 3 ebenfalls an seiner Soll-Lage befindet, muss der Bondkopf 6 nur vom Ort, wo jeweils mittels der ersten Kamera 7 die Lage des Halbleiterchips 2 bestimmt wird, in y-Richtung um eine vorbestimmte Distanz ΔY₀ bewegt werden, um den Halbleiterchip 2 auf dem Substratplatz 3 abzusetzen.

Die Montage des Halbleiterchips 2 auf dem Substrat 4 erfolgt gemäss den folgenden Schritten, wobei bei diesem Beispiel davon ausgegangen wird, dass die Bewegungsachse 18 (und nicht das Transportsystem für den Transport der Substrate 4 in x-Richtung) benützt wird, um den Halbleiterchip 2 in x-Richtung korrekt über dem Substratplatz 3 zu positionieren.

Die Bewegungsachse 18, die y-Achse des Bondkopfs 6 und der Drehwinkel θ des Chipgreifers 11 stellen also bei diesem Beispiel die drei Bewegungsachsen dar, die den drei Freiheitsgraden zugeordnet sind. Ihre Positionen werden im folgenden mit X, Y und θ bezeichnet.

In einer ersten Phase wird der Halbleiterchip 2 vom Wafertisch 15 entnommen, von der Flipvorrichtung 16 gewendet und an den Bondkopf 6 übergeben. Für die Durchführung dieser Schritte ist eine Konstruktion des Montageautomaten besonders geeignet, bei der der Halbleiterchip 2 von der Flipvorrichtung 16 vom Wafertisch 15 entnommen, gewendet und dann an einem vorbestimmten Ort an den Bondkopf 6 übergeben wird. Die erste Phase erfolgt dann beispielsweise so:
- Verschieben des Wafertisches 15 so, dass der nächste Halbleiterchip 2 für die Aufnahme durch die Flipvorrichtung 16 bereit liegt.
- Aufnehmen eines Bildes des bereitgestellten Halbleiterchips 2, um zu überprüfen, ob sich der Halbleiterchip 2 an der richtigen Stelle befindet und, falls schlechte Halbleiterchips markiert sind, prüfen, ob der Halbleiterchip 2 ein guter oder schlechter Halbleiterchip ist.
- Falls der Halbleiterchip 2 ein guter Halbleiterchip ist, Ablösen des Halbleiterchips 2 vom Wafertisch 15 und Aufnehmen des Halbleiterchips 2 durch die Flipvorrichtung 16.
- Mit der Flipvorrichtung 16 Flippen des Halbleiterchips 2, d.h. Drehen des Halbleiterchips um eine zur Oberfläche mit den Bumps parallele Achse um 180°,
- Drehen des Chipgreifers 11 in eine vorbestimmte Drehlage, die im folgenden mit dem Drehwinkel θ₁ bezeichnet wird.
- Bewegen der Bewegungsachse 18 in eine vorbestimmte Position, die im folgenden als X₁ bezeichnet wird.
- Übergeben des Halbleiterchips 2 von der Flipvorrichtung 16 an den Bondkopf 6.
- Bereitstellen des Substratplatzes 3, auf dem der Halbleiterchip 2 zu montieren ist.
- Benetzen der Bumps 1 des Halbleiterchips 2 mit Flussmittel. Dieser Schritt kann entfallen, wenn alternativ die Pads 10 des Substrats 4 mit Flussmittel versehen oder sogenannte Tapes verwendet werden.
- Positionieren des Bondkopfs 6 in einer vorbestimmten y-Position so, dass sich die beiden Referenzmarken 12, 13 und 14 und der Halbleiterchip 2 im Blickfeld der ersten Kamera 7 befinden. Diese y-Position wird als Y₁ bezeichnet.

Die drei Bewegungsachsen befinden sich also in der Position X₁, Y₁ und θ₁.

Nun folgen in einer zweiten Phase die Schritte, die das erfindungsgemässe Verfahren kennzeichnen.
A) Mit der ersten Kamera 7 Aufnehmen eines Bildes des Halbleiterchips 2, wobei das Bild sowohl die Bumps 1 des Halbleiterchips 2 als auch die am Bondkopf 6 angebrachten Referenzmarken 12, 13 und 14 enthält, Bestimmen der Ist-Lage des Halbleiterchips 2 in Bezug auf ein durch die drei Referenzmarken 12, 13 und 14 definiertes Koordinatensystem und Berechnen eines ersten Korrekturvektors v₁, der die Abweichung der Ist-Lage des Halbleiterchips 2 von seiner Soll-Lage beschreibt. Die Bestimmung der Ist-Lage des Halbleiterchips 2 erfolgt entweder durch Auswertung der Lage der Bumps 1 oder der Lage von auf dem Halbleiterchip 2 angebrachten Referenzmarken, sogenannten Fiducials.
   Die Abweichung der Ist-Lage des Halbleiterchips 2 von seiner Soll-Lage ist durch drei Größen Δx₁, Δy₁ und Δθ₁ charakterisiert, wobei Δx₁ und Δy₁ die Verschiebung eines Referenzpunktes P des Halbleiterchips 2 in x-Richtung bzw. y-Richtung und Δθ₁ die Verdrehung des Halbleiterchips 2 um den Referenzpunkt P bezeichnen. Der Korrekturvektor v₁ ist also gegeben durch v₁ = (Δx₁, Δy₁, Δθ₁). Im Beispiel ist der Referenzpunkt P der Mittelpunkt der Soll-Lage des Halbleiterchips 2.

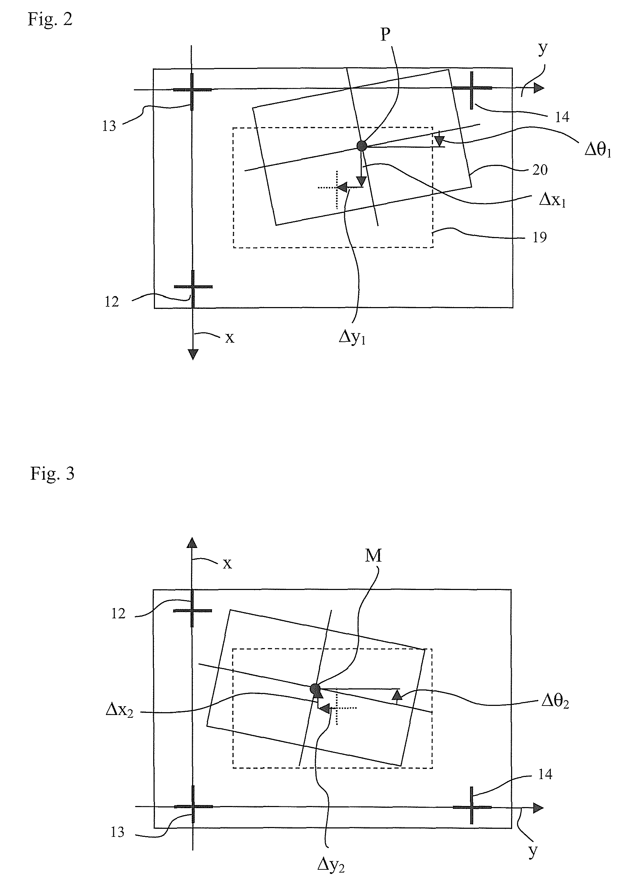

   Die Fig. 2 verdeutlicht diesen Sachverhalt. Die Referenzmarken 12, 13 und 14 definieren ein lokales Koordinatensystem mit zwei kartesischen, d.h. senkrecht aufeinander stehenden Koordinatenachsen x und y. Die Fig. 2 zeigt die mit einem gestrichelten Rechteck 19 dargestellte Soll-Lage und die mit einem ausgezogenen Rechteck 20 dargestellte Ist-Lage des Halbleiterchips 2, sowie die drei Referenzmarken 12, 13 und 14. Der Korrekturvektor v₁ gibt an, um welche Werte die Bewegungsachsen bewegt werden müssen, damit die Ist-Lage des Halbleiterchips 2 mit seiner Soll-Lage zusammenfällt. Die Achsen des Rechtecks 19 verlaufen vorzugsweise parallel zu den Koordinatenachsen x und y und sein Zentrum befindet sich z. B. im Zentrum eines durch die drei Referenzmarken 12, 13 und 14 aufgespannten Rechtecks.
B) Mit der zweiten Kamera 8 Aufnehmen eines Bildes des Substrats 4, Bestimmen der Ist-Lage des Substratplatzes in Bezug auf das durch die drei Referenzmarken 12, 13 und 14 definierte Koordinatensystem, wobei für die Position der drei Referenzmarken 12, 13 und 14 deren Lage R₀ verwendet wird, die sie einnehmen, wenn sich die Bewegungsachsen am Ort (X₁+Δx, Y₁+ΔY₀+Δy, θ₁+Δθ) befinden, und Berechnen eines zweiten Korrekturvektors v₂, der die Abweichung der Ist-Lage des Substratplatzes von seiner Soll-Lage beschreibt. (Aus diesem Grund sind die an sich im Bild nicht vorhandenen Referenzmarken in der Fig. 1 in grauer Farbe trotzdem als Referenzmarken 12', 13' dargestellt). Die Bedeutung der Werte Δx, Δy und Δθ wird weiter unten erläutert. Die Bestimmung der Ist-Lage, d.h. der translatorischen Lage und der Orientierung, des Substratplatzes 3 erfolgt entweder durch Auswertung der Lage seiner Pads 10 oder durch Auswertung der Lage von auf dem Substrat 4 angeordneten Referenzmarken.
   Die Abweichung der Ist-Lage des Substratplatzes 3 von seiner Soll-Lage ist durch drei Koordinaten Δx₂, Δy₂ und Δθ₂ charakterisiert, wobei Δx₂ und Δy₂ die Verschiebung eines Referenzpunktes S des Substratplatzes 3 in x-Richtung bzw. y-Richtung und Δθ₂ die Drehung des Substratplatzes 3 um den Referenzpunkt S bezeichnen. Der zweite Korrekturvektor v₂ ist also gegeben durch v₂ = (Δx₂, Δy₂, Δθ₂). Im Beispiel ist der Referenzpunkt S der Mittelpunkt der Soll-Lage des Substratplatzes 3.
   Die Fig. 3 verdeutlicht diesen Sachverhalt. Die Fig. 3 zeigt als gestricheltes Rechteck 21 die Soll-Lage und als ausgezogenes Rechteck 22 die Ist-Lage des Substratplatzes 3, sowie die unter der Annahme, dass sich die Bewegungsachsen am Ort (X₁+Δx, Y₁+ΔY₀+Δy, θ₁+Δθ) befinden, berechnete Lage der drei Referenzmarken 12, 13 und 14 (Die Referenzmarken 12, 13 und 14 sind im Bild der Kamera 8 nicht enthalten). Die Soll-Lage des Substratplatzes 3 ist entsprechend der Soll-Lage des Halbleiterchips 2 dadurch charakterisiert, dass der Mittelpunkt M des Substratplatzes 3 im Zentrum eines durch die drei Referenzmarken 12, 13 und 14 definierten Rechtecks liegt und dass die Pads 10 des Substratplatzes 3 parallel zu der x- bzw. y-Achse angeordnet sind. Der Korrekturvektor v₂ gibt an, um welche Werte die Bewegungsachsen bewegt werden müssen, damit die Ist-Lage des Substratplatzes 3 mit seiner Soll-Lage zusammenfällt.
   Die Werte Δx, Δy und Δθ stellen einen Vektor v dar. Der erste Halbleiterchip 2 eines Produktionsloses kann montiert werden unter der Annahme Δx = 0, Δy = 0 und Δθ = 0, da ein dadurch bedingter allfälliger Fehler im weiteren Verlauf des Verfahrens eliminiert wird.
C) Berechnen der anzufahrenden Positionen der drei Bewegungsachsen unter Berücksichtigung der beiden Korrekturvektoren v₁ und v₂, sowie des Vektors v zu
   (X₁+Δx₁+Δx₂+Δx, Y₁+ΔY₀+Δy₁+Δy₂+Δy, θ₁+Δθ₁+Δθ₂+Δθ), d.h. zu
   X₁+Δx₁+Δx₂+Δx für die Position des Bondkopfs 6 entlang der x-Achse, im Beispiel für die Bewegungsachse 18,
   Y₁+ΔY₀+Δy₁+Δy₂+Δy für die Position des Bondkopfs 6 entlang der y-Achse, und
   θ ₁+Δθ₁+Δθ₂+Δθ für den Drehwinkel des Chipgreifers 11.
D) Bewegen der drei Bewegungsachsen in diese berechneten Positionen.
E) Mit der zweiten Kamera 8 Aufnehmen eines Bildes, wobei das Bild jetzt die am Bondkopf 6 angebrachten Referenzmarken 12, 13 und 14 enthält, und Bestimmen der Ist-Lage R₁ der drei Referenzmarken 12, 13 und 14.
F) Berechnen eines dritten Korrekturvektors v₃=(Δx₃, Δy₃, Δθ₃), der die Abweichung der Ist-Lage R₁ der Referenzmarken 12, 13 und 14 von deren bei der Bestimmung des zweiten Korrekturvektors v₂ verwendeten Lage R₀ beschreibt.
G) Falls mindestens eine Komponente des dritten Korrekturvektors v₃ grösser als ein vorgegebener Grenzwert ist, Bewegen der entsprechenden Bewegungsachse in eine neue, um die entsprechende Komponente des Korrekturvektors v₃ korrigierte Position oder Bewegen aller drei Bewegungsachsen in neue, um den dritten Korrekturvektor v₃ korrigierte Positionen. Im letzteren Fall also in die Positionen (X₁+Δx₁+Δx₂+Δx₃+Δx, Y₁+ΔY₀+Δy₁+Δy₂+Δy₃+Δy, θ₁+Δθ₁+Δθ₂+Δθ₃+Δθ).
H) Anpassen des Vektors v zu v= v + v₃.
I) Absetzen des Halbleiterchips 2 auf dem Substratplatz 3.

Die Korrekturvektoren v₁ und v₂ charakterisieren allfällige Lagefehler des Halbleiterchips 2 bzw. des Substratplatzes 3. Der Vektor v charakterisiert die durch thermische Einflüsse insgesamt aufgelaufenen Lageverschiebungen der einzelnen Komponenten des Montageautomaten. Der dritte Korrekturvektor v₃ charakterisiert die durch thermische Einflüsse aufgetretenen Veränderungen. Das beschriebene Verfahren gewährleistet somit einerseits, dass bereits der erste Halbleiterchip eines Produktionsloses richtig montiert wird, und andererseits, dass thermische Lageverschiebungen laufend kompensiert werden, ohne dass die Bewegungsachsen ständig neu kalibriert werden müssen.

Die beschriebene Reihenfolge der Verfahrensschritte kann unter Umständen von der angegebenen Reihenfolge abweichen, da gewisse Schritte parallel oder in umgekehrter Reihenfolge durchgeführt werden können.

Die Schritte A, B, C, D und I werden immer durchgeführt. Die Schritte E, F, G und H werden immer dann durchgeführt, wenn der Vektor v noch nicht mit der erforderlichen Genauigkeit bekannt ist oder wenn zu erwarten ist, dass der Vektor v sich geändert haben könnte. Falls nötig, können die Schritte E, F, G und H mehrmals nacheinander durchgeführt werden, bis alle Komponenten des dritten Korrekturvektors v₃ kleiner als ein vorgegebener Grenzwert sind.

Die drei Referenzmarken 12, 13 und 14 sind bevorzugt auf einem Plättchen aus Glas in der Form von strukturierten Markierungen aus Chrom angebracht. Glas ist durchsichtig, so dass die Referenzmarken 12, 13 und 14 von beiden Kameras 7 und 8 gesehen werden. Bevorzugt wird ein Glas gewählt, dessen thermischer Ausdehnungskoeffizient möglichst gering ist. Die Abmessungen des Plättchens sind grösser als die Abmessungen des grössten zu montierenden Halbleiterchips gewählt und die Referenzmarken 12, 13 und 14 in der Nähe des Randes platziert, so dass die Referenzmarken 12, 13 und 14 unabhängig von der Grösse des Halbleiterchips von beiden Kameras 7 und 8 sichtbar sind.

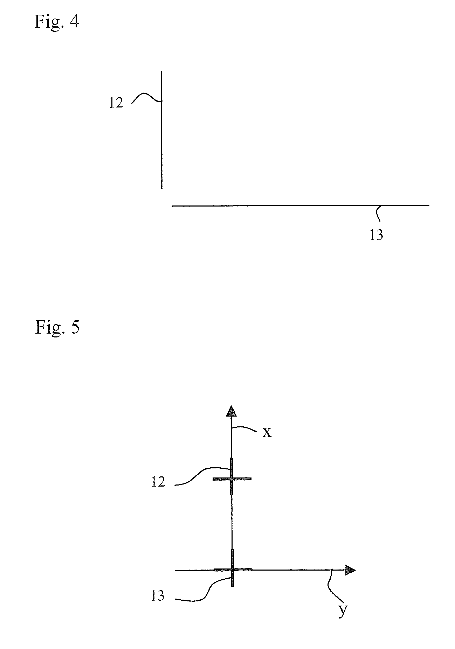

Die Funktion der Referenzmarken 12, 13 und 14 besteht darin, ein lokales Koordinatensystem zu definieren, in Bezug auf das die Soll-Lage des Halbleiterchips wie auch die Soll-Lage des Substratplatzes definiert wird. Als Referenzmarken gelten im Sinne der Erfindung auch andere Lösungen, die diese Funktion erfüllen. So können an Stelle der drei Referenzmarken 12, 13 und 14 beispielsweise zwei Referenzmarken 12 und 13 vorgesehen sein, die durch zwei orthogonal zueinander ausgerichtete Linien gebildet sind, wie dies in der Fig. 4 gezeigt ist. Die Referenzmarke 12 definiert die Lage der x-Achse, die Referenzmarke 13 definiert die Lage der y-Achse des lokalen kartesischen Koordinatensystems. Eine weitere Lösung ist in der Fig. 5 gezeigt. Hier definieren zwei Referenzmarken 12 und 13 die Lage der x-Achse des lokalen kartesischen Koordinatensystems. Die y-Achse des lokalen kartesischen Koordinatensystems ist dadurch definiert, dass sie senkrecht zur x-Achse und durch die Referenzmarke 12 hindurch verläuft.

Zwar werden hier zu illustrativen Zwecken gegenwärtig bevorzugte Ausführungsbeispiele und Anwendungen dieser Erfindung dargestellt und beschrieben, doch es sind Variationen und Modifikationen möglich, die innerhalb des Konzepts und des Geltungsbereichs dieser Erfindung bleiben. Diese Variationen treten für Fachpersonen nach dem Studium dieser Beschreibung klar zutage.

## Patentansprüche

1. Verfahren für die Montage eines auf einer Oberfläche mit Bumps (1) versehenen Halbleiterchips (2) auf einem Substratplatz eines Substrats (4), wobei die Bumps (1) in Kontakt mit entsprechenden Pads (10) des Substratplatzes gebracht werden, wobei die Positionierung des Halbleiterchips (2) über dem Substratplatz mittels dreier Bewegungsachsen erfolgt, mit den Schritten
- Aufnehmen des Halbleiterchips (2) von einem Wafertisch (15),
- Drehen des Halbleiterchips (2) um eine zur Oberfläche mit den Bumps (1) parallele Achse um 180°,
- Übergeben des Halbleiterchips (2) an einen Bondkopf (6),
- Bereitstellen des Substratplatzes (3),
**gekennzeichnet durch** die weiteren Schritte:
A) mit einer ersten Kamera (7) Aufnehmen eines Bildes des Halbleiterchips (2), wobei das Bild sowohl die Bumps (1) des Halbleiterchips (2) als auch am Bondkopf (6) angebrachte Referenzmarken (12 - 14) enthält, wobei sich die drei Bewegungsachsen in ersten Positionen befinden, und Bestimmen der Position und Orientierung der Ist-Lage des Halbleiterchips (2) in Bezug auf ein **durch** die Referenzmarken (12 - 14) definiertes Koordinatensystem und Berechnen eines ersten Korrekturvektors v₁, der die Abweichung der Ist-Lage des Halbleiterchips (2) von seiner Soll-Lage beschreibt,
B) mit einer zweiten Kamera (8) Aufnehmen eines ersten Bildes, wobei im Bild der Substratplatz (3) sichtbar ist, Bestimmen der Position und Orientierung des Substratplatzes (3) in Bezug auf das **durch** die Referenzmarken (12 - 14) definierte Koordinatensystem, wobei für die Positionen der Referenzmarken fiktive Positionen benützt werden, die sie einnehmen würden, wenn die drei Bewegungsachsen aus den ersten Positionen um einen Vektor v in zweite Positionen bewegt worden wären, und Berechnen eines zweiten Korrekturvektors v₂, der die Abweichung der Ist-Lage des Substratplatzes (3) von seiner Soll-Lage beschreibt,
C) Berechnen der anzufahrenden Positionen der drei Bewegungsachsen unter Berücksichtigung des Vektors v und der beiden Korrekturvektoren v₁ und v₂,
D) Bewegen der drei Bewegungsachsen in diese berechneten Positionen, und
E) Absetzen des Halbleiterchips (2) auf dem Substratplatz (3).

2. Verfahren nach Anspruch 1, **dadurch gekennzeichnet, dass** nach dem Schritt D die folgenden Schritte durchgeführt werden:
- mit der zweiten Kamera (8) Aufnehmen eines zweiten Bildes, wobei im zweiten Bild die am Bondkopf angebrachten Referenzmarken (12 - 14) sichtbar sind, und Bestimmen der Ist-Lage der Referenzmarken (12-14),
- Berechnen eines dritten Korrekturvektors v₃, der die Abweichung der Ist-Lage der Referenzmarken (12-14) von der im Schritt B bei der Auswertung des ersten von der zweiten Kamera (8) aufgenommenen Bildes benützten fiktiven Positionen der Referenzmarken (12 - 14) beschreibt,
- Anpassen des Vektors v zu v = v + v₃,
- Falls mindestens eine Komponente des dritten Korrekturvektors v₃ grösser als ein vorgegebener Grenzwert ist, Bewegen mindestens der dieser Komponente entsprechenden Bewegungsachse in eine neue, korrigierte Position.
